Europäisches Patentamt

European Patent Office

Office européen des brevets

(11) Publication number: **0 265 988**
**A1**

## (12) EUROPEAN PATENT APPLICATION

(21) Application number: **87201965.8**

(22) Date of filing: **13.10.87**

(51) Int. Cl.⁴: **H01L 21/105** , H01L 29/167

(30) Priority: **29.10.86 IT 661686**

(43) Date of publication of application:
**04.05.88 Bulletin 88/18**

(84) Designated Contracting States:
**CH DE GB LI NL**

(71) Applicant: **SGS MICROELETTRONICA S.p.A.**
**Stradale Primosole 50**
**I-95121 Catania(IT)**

(72) Inventor: **Ferla, Giuseppe**
**Via Acicastello 12**
**I-95100 Catania CT(IT)**
Inventor: **Beretta, Giorgio**
**Via R. Imbriani 189**
**I-95100 Catania CT(IT)**

(74) Representative: **Arena, Giovanni**
**Viale Certosa 135**
**I-20151 Milano(IT)**

(54) Epitaxial layers with controlled quantities of nitrogen, grown on silicon substrates and method for producing the same.

(57) A description is given of a substrate of semiconductor material for manufacture of semiconductor devices, consisting of a first layer of sylicon single crystal on which at least a second layer of silicon single crystal is grown epitaxially, said second layer containing a quantity of nitrogen comprised between $0.5 \cdot 10^{15}$ and $10 \cdot 10^{15}$ atoms/cm³, the result of which is to make available, for subsequent manufacturing stages of the devices, wafers of silicon possessing highly elastic mechanical characteristics and free of lattice defects in the epitaxial layers.

EP 0 265 988 A1

## "EPITAXIAL LAYERS WITH CONTROLLED QUANTITIES OF NITROGEN, GROWN ON SILICON SUBSTRATES AND METHOD FOR PRODUCING THE SAME."

The present invention concerns substrates of semiconductor material, typically silicon wafers, for the production of semiconductors such as transistors and integrated circuits.

The silicon substrates, available on the market for manufacture of semiconductor devices, show several drawbacks whose negative effects appear during the subsequent thermal processes carried out at high temperatures.

Whether they originate from CZOCHRALSKI (CZ) single crystals or from FLOATING ZONE (FZ) single crystals, the mechanical properties of said substrates are inadequate (FZ) or vary in a way that it is hard to control (CZ). This means that the thermal stresses, inevitable during the manufacturing stages of the semiconductor devices, are absorbed by said substrates involving plastic warpage which gives rise to lattice defects, the density of which may be high, such as dislocations, slip-lines. etc.. These defects not only limit the elastic properties of the wafers but also spread to the epitaxial layers that will be formed on the substrates; the result is a considerable lowering of production yields of electronic products.

It is well known that, at the present state of the art, the silicon substrates available on the market contain undesired non-doping impurities which the manufacturers tend to keep within minimum limits. These impurities consist mainly of oxygen, nitrogen, carbon, hydrogen and heavy metals.

During growth of the CZOCHRALSKI ingot, from which CZ substrates are obtained, controlled introduction of nitrogen is not usually resorted to. If nitrogen is introduced in extremely small quantities during growth of the silicon single crystal by CZ technique, as mentioned in the Europ. Pat. Appl. Publ. N° 162.830, this is done in order to increase thermal precipitation of the oxygen, which is also present in the crystal, by giving special heat treatments to the Cz substrates; this is therefore done to improve the gettering properties by means of the oxygen precipitates which act as gettering centres of contaminating impurities that have to be removed from the active zones of the devices to avoid lowering their electrical performance.

In the course of growth of the FLOATING ZONE ingot, and thus in the FZ substrates, nitrogen is absent because it is eliminated during the process of manufacture and purification of the FZ ingot. But the lack of nitrogen in the FZ silicon substrates worsens them compared with those of CZ origin because slippage is generated. In a .publication by T.Abe et al., entitled "Impurities in silicon single crystals", which appeared at the Symposium on Semiconductor Silicon held from May. 11 to 15, 1981, it was therefore suggested to produce FZ ingots with small quantities of nitrogen present, but substrates from this ingot have never been produced and put on the market. Even if they were, however, they would not guarantee extension of the mechanical properties, derived from the controlled addition of nitrogen, to an epitaxial layer grown on them.

As stated in the above publication by T.Abe et al., about 90% of the silicon single crystals used in industrial manufacture of semiconductor devices, are in fact obtained by the CZOCHRALSKI method.

But as already stated, the CZOCHRALSKI substrates contain oxygen and even if nitrogen is added to increase thermal precipitation of the oxygen - in order to improve the gettering properties of the oxygen in the single crystal-formation of lattice defects cannot all the same be avoided during heat treatments; these defects do not remain stationary but spread into the substrate and also into the epitaxial layers grown onto them by the manufacturer of devices, which in the end worsens the crystallographic quality of the single crystal.

Further, said lattice defects generate entirely alone during the growth of an epitaxial layer and the thicker the layer the more numerous are the defects thus worsening even more the crystallographic quality of the single crystal.

The main object of the present invention is to grow at least one epitaxial layer possessing properties such as will confer highly elastic mechanical characteristics on the epitaxiated silicon substrates and such as will eliminate as far as possible any lattice defects. Another aim is to prevent migration of the lattice defects present in the substrate, stopping them at the interface of the substrate by means of an epitaxial layer grown on it.

In accordance with the invention, these and other objects are achieved by using small controlled quantities of nitrogen to realize at least one epitaxial layer of silicon single crystal, by introducing said quantities during epitaxial growth in concentrations between $0.5 \cdot 10^{15}$ and $10 \cdot 10^{15}$ atoms/$cm^3$, such as will stop the beginning and spread of lattice defects in the epitaxially grown crystal. The invention will be better understood by the following detailed description of one example of its execution, thus not limited to that one.

In the following example CZOCHRALSKI silicon substrates, 125 mm diameter, <111> oriented, doped with antimony and possessing resistivity less or equal to $20 \bullet 10^{-3}$ ohm.cm, are placed in a reaction chamber of an apparatus for vapor phase epitaxy growth at ambient pressure and at a temperature of 1170 °C.

The aforesaid commercial substrates contain, at the most, less than $1 \bullet 10^{15}$ atoms/cm$^3$ of nitrogen in the non ionized state.

On said substrates an epitaxial silicon layer, to which pure nitrogen $N_2$ has been added at established concentrations, is formed using the epitaxial growth techniques which consist of putting into the reaction chamber hydrogen $H_2$ added to silicon tetrachloride $SiCl_4$ and to nitrogen $N_2$, at a growth rate of the epitaxial layer of 1.35 μm/minute.

Introduction of very small and controlled quantities of pure nitrogen into the reaction chamber is made by use of a mass flow controller known to experts in this field. The silicon substrates are treated so as to cause growth upon them of an epitaxial layer of silicon single crystal having a pre-determined thickness, for example 55 μm, and a pre-determined nitrogen content, chosen from a range of values between $0.5 \bullet 10^{15}$ and $10 \bullet 10^{15}$ atoms/cm$^3$, for example $3.0 \bullet 10^{15}$ atoms/cm$^3$.

However thick the epitaxial film grown on the substrates may be, there must not be more than $10 \bullet 10^{15}$ atoms/cm$^3$ of nitrogen present in the silicon single crystal because it causes formation of silicon nitride $Si_3N_4$, leading to imperfections in the lattice of the crystal.

Epitaxial growth having been effected, all the wafers epitaxiated by introduction of nitrogen within the limits given above, were tested and measured, results being obtained that were far superior to commercial epitaxiated wafers made by the known technique, namely in the absence of nitrogen. In particular, excellent results were obtained for epitaxiated wafers having a nitrogen content between 2 and $4 \bullet 10^{15}$ atoms/cm$^3$, which showed no lattice defects of dislocations and slip lines and which have been found to possess excellent properties of mechanical resistance.

It has therefore been proved how extremely useful the presence of nitrogen is during epitaxial growth of silicon for the production of semiconductor devices, in order to obtain quantities between $0.5 \bullet 10^{15}$ and $10 \bullet 10^{15}$ atoms/cm$^3$ of nitrogen enclosed in the crystal.

Although only one example of execution of the present invention has been described and explained, it is clear that numerous viarations and modifications can be made to it without departing from the scope of the invention. For example, the epitaxial layer containing the indicated quantities of nitrogen can be obtained by putting nitrogen compounds, $NH_3$ for example, in the reaction chamber.

As a further example, it is possible to obtain epitaxial layers containing controlled quantities of nitrogen and doping impurities of N or P type conductivity, by putting not only nitrogen or one of its compounds into the reaction chamber but also the relative doping gases of N or P type conductivity, according to the procedures well known to men skilled in the art, since nitrogen at the indicated concentrations does not possess doping properties and so, for example, does not cause variations in electric conductivity of the layer.

Clearly, on a silicon substrate more than one epitaxial layer can be grown in succession, each containing nitrogen.

In that case at least the innermost layer, in contact with the substrate, must contain nitrogen in order to prevent the lattice defects present in the substrate from spreading to the other epitaxial layers grown onto it. Finally it is obvious that the invention applies to silican substrates whatever their diameter and crystallographic orientation.

## Claims

1. Substrate of semiconductor material for producing semiconductor devices comprising a first layer of silicon single crystal and a second layer of silicon single crystal grown epitaxially on the first, chracterized by the fact that the second layer contains nitrogen, the quantity of said nitrogen, present as a non-doping impurity, being sufficient to prevent the onset and spread of lattice defects in the epitaxially grown crystal of the second layer.

2. Substrate according to claim 1, characterized by the fact that said second layer contains, in addition to the nitrogen, doping impurities having N type conductivity.

3. Substrate according to claim 1 characterized by the fact that said second layer contains, in addition to the nitrogen, doping impurities having P type conductivity.

4. Substrate according to claim 1 or 2 or 3, characterized by the fact that the content of nitrogen in said second layer is maintained in predetermined concentrations comprised between $0.5 \bullet 10^{15}$ and $10 \bullet 10^{15}$ atoms/cm$^3$.

5. Method for producing semiconductor devices comprising a first layer of silicon single crystal and a second layer of silicon single crystal grown epitaxially on the first, characterized by the fact that the relevent equipment comprises a system for introducing controlled quantities of nitrogen into the reaction chamber, in order to obtain nitrogen included in the second layer, the quantity of said nitrogen, present as non-doping impurity, being sufficient to prevent the onset and spread of lattice defects in the epitaxially grown crystal of the second layer.

6. Method for producing semiconductor devices comprising a first layer of silicon single crystal and a second layer of silicon single crystal grown epitaxially on the first, characterized by the fact that the relevant equipment comprises a system for introducing controlled quantities of nitrogen compounds into the reaction chamber, in order to obtain nitrogen included in the second layer, the quantity of said nitrogen, present as non-doping impurity, being sufficient to prevent the onset and spread of lattice defects in the epitaxially grown crystal of the second layer.

7. Method according to claim 5 or 6, characterized by the fact that the content of nitrogen in said second layer is mantained in predetermined concentrations comprised between $0.5 \bullet 10^{15}$ and $10 \bullet 10^{15}$ atoms/cm$^3$.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y,D | SYMPOSIUM ON SEMICONDUCTOR SILICON, 11th-15th May 1981, pages 54-71; T. ABE et al.: "Impurities in silicon single crystals" * Page 62, "5. Nitrogen" - page 64, line 16 * | 1-7 | H 01 L 21/205 H 01 L 29/167 |
| Y | FR-A-2 318 678 (R.T.C. LA RADIOTECHNIQUE COMPELEC) * Page 4, line 37 - page 5, line 13 * | 1-7 | |
| A | JOURNAL OF THE ELECTROCHEMICAL SOCIETY, vol. 120, no. 7, July 1973, pages 975-979, Princeton, NJ, US; Y. YATSURUGI et al.: "Concentration, solubility, and equilibrium distribution coefficient of nitrogen and oxygen in semiconductor silicon" * Abstract; page 976, column 2, "Results and discussion" - page 977, column 1, line 13 * | 1-7 | |
| A | PATENT ABSTRACTS OF JAPAN, vol. 10, no. 313 (E-448)[2369], 24th October 1986; & JP-A-61 125 012 (TOSHIBA CORP.) 12-06-1986 * Abstract * | 1-7 | TECHNICAL FIELDS SEARCHED (Int. Cl.4) H 01 L |

The present search report has been drawn up for all claims

| Place of search | Date of completion of the search | Examiner |
|---|---|---|
| THE HAGUE | 11-01-1988 | GELEBART Y.C.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)